# EUROPÄISCHE PATENTSCHRIFT

(11) **EP 1 330 845 B1**
(45) Veröffentlichungstag und Bekanntmachung des Hinweises auf die Patenterteilung: **10.09.2008**
(21) Anmeldenummer: 01993026.2
(22) Anmeldetag: 19.09.2001
(51) Int. Cl.: H01L 29/788, H01L 29/423

(54) **HALBLEITER-SPEICHERZELLE UND VERFAHREN ZU DEREN HERSTELLUNG**
SEMICONDUCTOR MEMORY CELL AND METHOD FOR PRODUCING THE SAME
CELLULE DE MEMOIRE A SEMI-CONDUCTEUR ET SON PROCEDE DE FABRICATION

(30) Priorität: 02.11.2000 DE 10054172
(43) Veröffentlichungstag der Anmeldung: 30.07.2003
(73) Patentinhaber: Infineon Technologies AG, 81669 München (DE)
(72) Erfinder: GEHRING, Oliver, 01187 Dresden (DE)
(74) Vertreter: Barth, Stephan Manuel
(86) Internationale Anmeldenummer: PCT/EP2001/010834
(87) Internationale Veröffentlichungsnummer: WO 2002/037575

(56) Entgegenhaltungen:
- DE-A- 19 811 080
- US-A- 5 598 367
- PATENT ABSTRACTS OF JAPAN vol. 007, no. 280 (E-216), 14. Dezember 1983 (1983-12-14) -& JP 58 158973 A (DAINI SEIKOSHA KK), 21. September 1983 (1983-09-21)
- PATENT ABSTRACTS OF JAPAN vol. 016, no. 297 (E-1226), 30. Juni 1992 (1992-06-30) -& JP 04 079369 A (TOSHIBA CORP), 12. März 1992 (1992-03-12)
- PATENT ABSTRACTS OF JAPAN vol. 008, no. 194 (E-264), 6. September 1984 (1984-09-06) -& JP 59 082770 A (KOGYO GIJUTSUIN;OTHERS: 0J), 12. Mai 1984 (1984-05-12)

## Beschreibung

Die vorliegende Erfindung betrifft eine Halbleiter-Speicherzelle und ein Verfahren zu deren Herstellung.

Obwohl prinzipiell auf beliebige Halbleiter-Speicherzellen anwendbar, werden die vorliegende Erfindung sowie die ihr zugrundeliegende Problematik in bezug auf nicht-flüchtige Halbleiter-Speicherzellen in Siliziumtechnologie erläutert.

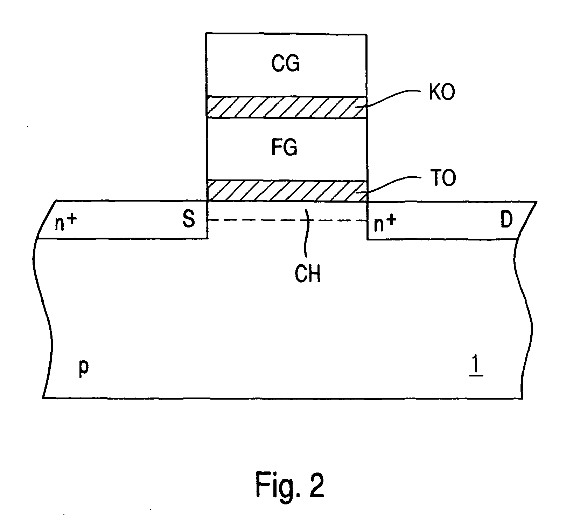

Fig. 2 zeigt eine schematische Darstellung des Aufbaus einer bekannten nicht-flüchtigen Speicherzelle in Siliziumtechnologie.

In Figur 2 bezeichnet Bezugszeichen 1 ein Silizium-Halbleitersubstrat vom p-Leitungstyp, in das ein n⁺-Sourcebereich S und ein n⁺-Drainbereich D eingebracht sind. Zwischen dem Sourcebereich S und dem Drainbereich D liegt ein Kanalgebiet CH. Oberhalb des Kanalgebiets CH ist ein Tunneloxid TO vorgesehen, oberhalb dessen sich wiederum ein Floating-Gate FG befindet. Auf dem Floating-Gate FG ist ein Koppeloxid KO vorgesehen, oberhalb dessen sich ein Control-Gate CG befindet.

Im Betrieb dieser bekannten nicht-flüchtigen Speicherzelle werden durch Anlegen einer äußeren Spannung zwischen dem Control-Gate CG und dem Kanal bzw. dem Source-/Drainbereich S, D Ladungsträger zum Durchtunneln des Tunneloxids TO bewegt. Die Spannung des Control-Gates CG wird dabei kapazitiv über das Koppeloxid KO auf das Floating-Gate FG übertragen. Durch den aktuellen Ladungszustands des Floating-Gates FG wird die Einsatzspannung des Transistors bestimmt, was letztlich die gespeicherte Information beinhaltet.

Die Wettbewerbsfähigkeit hinsichtlich Kosten und Performance von nicht-flüchtigen Speicheranordnungen kann nur durch fortlaufende Miniaturisierung gewährleistet werden. Derzeit werden interne Spannungen bis zu 19 V benötigt, um die bekannten nicht-flüchtigen Zellen, wie zum Beispiel in Figur 2 illustriert, zu programmieren bzw. zu löschen. Um Spannungen dieser Größenordnung zu handhaben, muss relativ viel Chipfläche für die Isolation (z.B: triple wells, "Channel Stop"-Gegenimplantationen, zurückgezogene Diffusionsgebiete, lateral vergrößerte Isolationen) und die interne Spannungserzeugung (Ladungspumpen) aufgewendet werden.

Zunehmende Verkleinerungen von den Technologien nichtflüchtiger Speicher (Flash, EEPROM) lassen sich nur über eine Senkung der Programmierspannung erreichen. Diese wiederum ist abhängig von der Koppelkapazität zwischen den Floating-Gate FG und der Programmierleitung (Wortleitung) bzw. dem Control-Gate CG. Eine möglichst große Koppelkapazität ist in diesen Zusammenhang erwünscht.

Des weiteren wurde bei den heutigen Speichergenerationen aufgrund der Komplexität der Herstellungsprozesse eine Integration zwischen RAM-Speichern (Schreibt-/Lesespeicher) und NVM-Speichern (nicht-flüchtige Speicher) noch nie ernsthaft erwogen. Die gemischte Fertigung von DRAM- und NVM-Technologien auf einem gemeinsamen Anlagenpark würde derzeit massive Aufwände bezüglich Anlagenumrüstung erfordern und wäre von schlechten Anlagenauslastungen und einem erhöhten Aufwand für Produktionsplanung und Prozessunterstützung begleitet.

Aus dem Stand der Technik sind folgende Dokumente bekannt. JP58158973 offenbart ein Control-Gate, welches als dotiertes Substratgebiet ausgebildet ist. US5598367 offenbart eine nichtflüchtige Speicherzelle mit einem lateralen Transistor und einem vertikalen Transistor, dessen Control-Gate ein dotiertes Substratgebiet ist, welches ein in einem Graben angebrachtes Floating-Gate umgibt. JP04079369 offenbart vertikale Speicherzellen, bei denen Control- und Floating-Gate seitlich von Substraterhöhungen angebracht sind. DE19811080 offenbart eine in einem Graben angeordnete Floating-Gate-Elektrode. JP59082770 offenbart Floating- und Control-Gates, die in einer isolierenden Schicht oberhalb des Substrats vergraben sind.

Die Aufgabe der vorliegenden Erfindung besteht darin, eine verbesserte Halbleiter-Speicherzelle bzw. ein entsprechendes Herstellungsverfahren anzugeben, wobei die Koppelkapazität erhöht ist.

Erfindungsgemäß wird diese Aufgabe durch die in Anspruch 1 angegebene Halbleiter-Speicherzelle und das in Anspruch 6 angegebene Herstellungsverfahren gelöst.

Die der vorliegenden Erfindung zugrundeliegende Idee besteht darin, daß eine Zelle gebildet wird, bei der die Gatestruktur im Substrat untergebracht ist.

Es wird ein bekannter gefüllter Deep Trench der DRAM-Technologie hergenommen, um darin das Floating-Gate zu bilden. Diese Art von bekanntem Trench ist hinsichtlich der Kapazität optimiert, so dass sich der Koppelfaktor bzw. der Spannungsdurchgriff vom Control-Gate auf das Floating-Gate wesentlich erhöht und somit bei gleicher tunnelrelevanter Spannung zwischen Kanal und Floating-Gate die äußere Spannung zwischen Kanal und Control-Gate reduziert werden kann.

Damit reduzieren sich die Flächenaufwendungen zur lateralen Isolation erheblich. Im übrigen kann das Control-Gate vorzugsweise durch eine einfache Umdotierung des Grundmaterials des Halbleitersubstrats (z.B. Silizium) realisiert werden.

Ein weiterer Vorteil der erfindungsgemäßen Speicherzelle bzw. des entsprechenden Herstellungsverfahrens liegt darin, dass eine gemischte, bedarfsgerechte Fertigung von DRAM- und NVM-Technologien auf einem gemeinsamen Anlagenpark mit minimalen Prozessunterstützungsaufwand ermöglicht wird. Somit wird eine Integration von DRAM-, Logik- und NVM-Technologien in einem Baustein möglich. Dies hat außerdem eine Minimierung des Entwicklungsaufwandes für folgende Shrink-Generationen zur Folge.

Die Tatsache, dass bei der erfindungsgemäßen Speicherzelle das Control-Gate das Floating-Gate nahezu vollständig, d.h. mit Ausnahme des Kanalbereichs an der Oberfläche, umschließt, hat zur Folge, das die Koppelkapazität maximiert ist und daher der Spannungsbedarf sinkt. Zur Herstellung der erfindungsgemäßen Speicherzellen bedarf es keiner neuen Prozessschritte, da insbesondere die Bildung von Gräben bzw. Deep-Trenches bereits aus der DRAM-Fertigung wohl bekannt ist.

In den Unteransprüchen finden sich vorteilhafte Weiterbildungen und Verbesserungen der in Anspruch 1 angegebenen Halbleiter-Speicherzelle bzw. des in Anspruch 6 angegebenen Herstellungsverfahrens.

Gemäß einer bevorzugten Weiterbildung ist die Control-Gate-Elektrode ein Dotierungsbereich im Halbleitersubstrat.

Gemäß einer weiteren bevorzugten Weiterbildung ist die Floating-Gate-Elektrode eine Polysilizium-Füllung des Grabens.

Gemäß einer weiteren bevorzugten Weiterbildung ist die leitende Schicht eine Epitaxieschicht aus Polysilizium.

Gemäß einer weiteren bevorzugten Weiterbildung sind neben dem Graben STI-Gräben zur Isolation gegenüber benachbarten Speicherzellen vorgesehen.

Ein Ausführungsbeispiel der Erfindung ist in den Zeichnungen dargestellt und in der nachfolgenden Beschreibung näher erläutert.

Es zeigen:
- Fig. 1: eine schematische Darstellung einer Halbleiter-Speicherzelle gemäß einer ersten Ausführungsform der vorliegenden Erfindung; und
- Fig. 2: eine schematische Darstellung einer bekannten Halbleiter-Speicherzelle.

In den Figuren bezeichnen gleiche Bezugszeichen gleiche oder funktionsgleiche Bestandteile.

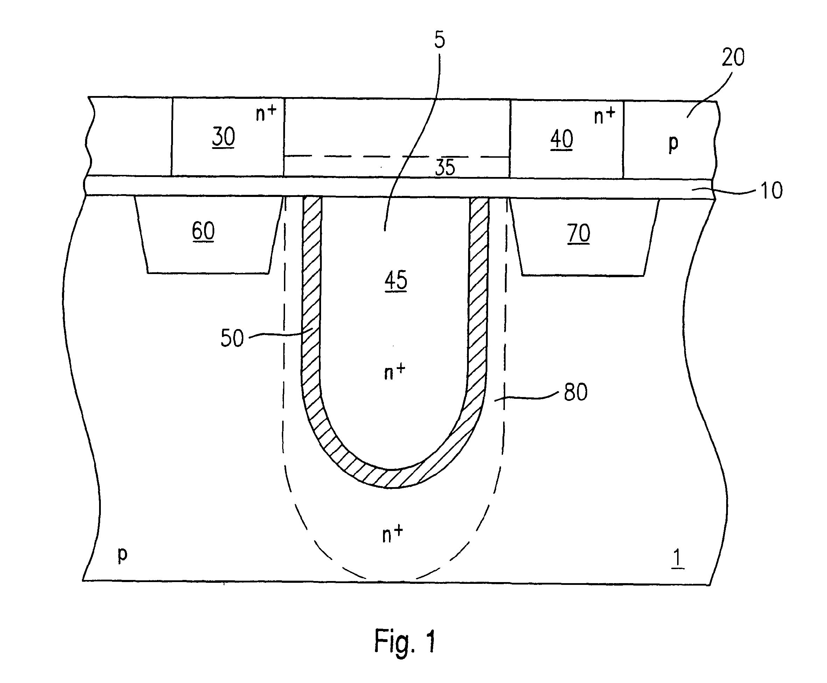

Fig. 1 zeigt eine schematische Darstellung einer Halbleiter-Speicherzelle gemäß einer ersten Ausführungsform der vorliegenden Erfindung.

In Figur 1 bezeichnet Bezugszeichen 1 ein Silizium-Halbleitersubstrat vom p-Leitungstyp. Im Halbleitersubstrat 1 ist ein Graben 5 vorgesehen, auf dessen Grabenwand sich eine SiO₂-Isolationsschicht 50 befindet. Die erste Isolationsschicht 50 dient als das an sich bekannte Koppeloxid. Eingebracht in den Graben 5 und von der Grabenwand durch diese Isolationsschicht 50 getrennt, ist eine Floating-Gate-Elektrode 45 aus Polysilizium.

Im Halbleitersubstrat 1 befindet sich um den Graben 5 herum ein n⁺-Bereich, welcher als Control-Gate-Elektrode 80 dient. Der Anschluss der Control-Gate-Elektrode 80 ist aus Figur 1 nicht ersichtlich und ist bei diesem Beispiel nach hinten aus der Zeichnungsebene heraus und an anderer Stelle an die Oberfläche des Halbleitersubstrats 1 geführt.

Links und rechts des derart gestalteten Grabens 5 befinden sich STI-Isolationsgebiete 60, 70 (STI = Shallow Trench Isolation).

Auf der Oberfläche des Halbleitersubstrats 1 vorgesehen ist eine zweite Isolationsschicht 10 aus SiO₂, die als Tunneloxid dient. Auf der zweiten Isolationsschicht 10 vorgesehen, ist eine leitende Schicht 20 aus Silizium, welche einen Kanalbereich 35 oberhalb der Floating-Gate-Elektrode 45 bildet. Neben dem Kanalbereich 35 befinden sich ein n⁺-Sourcebereich 30 und n⁺-Drehnbereich 40.

Die Speicherzelle gemäß dieser Ausführungsform hat dieselbe Funktionalität wie die bekannte Speicherzelle gemäß Figur 2. Jedoch steht ihr Aufbau quasi auf dem Kopf, denn die GateStruktur mit dem Floating-Gate 45 und dem Control-Gate 80 ist unterhalb des Kanalbereichs 35 im Halbleitersubstrat 1 angeordnet.

Im folgenden wird ein Herstellungsverfahren zur Herstellung der in Figur 1 gezeigten Speicherzelle beschrieben.

Zunächst wird das Halbleitersubstrat 1 vom p-Leitungstyp bereitgestellt. Bei diesem Halbleitersubstrat 1 kann es sich um ein Wafersubstrat oder ein sonstiges Substrat handeln, beispielsweise um ein SOI-Substrat oder ein Epitaxie-Substrat. Nach bekannter DRAM-Technologie wird in dem Substrat 1 der Graben 5 durch einen Ätzprozess gebildet. Es erfolgt eine Oxidation der Seitenwände des Grabens 5 zur Bildung der ersten Isolationsschicht 50 und darauf eine geeignete Implantation oder Diffusion zur Bildung des Control-Gates 80 als n⁺-Bereich im Halbleitersubstrat 1 um den Graben 5 herum. Danach wird n⁺-dotiertes Polysilizium abgeschieden und planarisiert, um das Floating-Gate 45 als Grabenfüllung zu bilden. Links und rechts des Grabens 5 werden nach bekannter Ätz- und Fülltechnik die STI-Gräben 60, 70 gebildet.

In einem weiteren Schritt erfolgt durch thermische Oxidation die Bildung der zweiten Isolationsschicht 10, d.h. des Tunneloxids. Ein Epitaxieschritt wird vorzugsweise zur Bildung der Siliziumschicht 20 oberhalb der zweiten Isolationsschicht 10 verwendet. Es folgt eine Maskierung und eine Einbringung von n-Dotierstoff zur Bildung des Source-/ Drainbereichs 30, 40.

Wie ersichtlich, lässt sich bei diesem neuen Herstellungsverfahren die Herstellung von DRAMs und NVMs gleichzeitig durchführen.

Ein Anwendungsbeispiel für einen solchen Prozess ist die Herstellung von Festplattencontrollern. Für diese Bauteile werden embedded DRAM Bausteine für Steuer- und Cachefunktionen benutzt, wohin gegen die Steuersoftware auf einem separaten EEPROM abgelegt ist. Die vorgeschlagene Technologie würde die Integration dieser Funktion auf einem Baustein ermöglichen.

Ein weiteres Anwendungsbeispiel sind Miniaturrechner (Handheld/Notebooks). Diese werden üblicherweise in embedded DRAM-Chips hergestellt. Mit integrierten Technologien lässt hier die Miniaturisierung durch Einbau von nicht-flüchtigen Speichern weiter voran treiben. Zudem entfällt lästiges Booten was Zeit- und Energievorteile schafft. In dem zusätzlich integrierten nicht-flüchtigen Speicher könnten sich das Betriebssystem und Anwendungsprogramme befinden, welche bisher auf der Festplatte vorgesehen sind.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Obwohl die vorliegende Erfindung anhand einer nicht-flüchtigen Speicherzelle in Silizium-Technologie erläutert wurde, ist die Erfindung nicht auf Silizium als Grundmaterial beschränkt. Auch die anderen Materialen und Verfahrensschritte im obigen Ausführungsbeispiel sind nur spezielle von vielen Möglichkeiten zur Realisierung der erfindungsgemäßen Speicherzelle.

### BEZUGSZEICHENLISTE:

- 1: Halbleitersubstrat
- 5: Graben
- 50: erste Isolationsschicht
- 10: zweite Isolationsschicht
- 20: leitende Schicht
- 30, 40: Source-, Drainbereich
- 35: Kanal
- 60, 70: STI-Gräben
- 80: Control-Gate-Elektrode
- 45: Floating-Gate-Elektrode

## Patentansprüche

1. Halbleiter-Speicherzelle mit:
einem Halbleitersubstrat (1);
einem in dem Halbleitersubstrat (1) vorgesehenen Graben (5);
einer in dem Graben (5) eingebrachten Floating-Gate-Elektrode (45), welche durch eine erste Isolationsschicht (50) von den Grabenwänden isoliert ist;
einer in dem Halbleitersubstrat (1) um den Graben (5) herum vorgesehenen Control-Gate-Elektrode (80);
einer auf der Oberfläche des Halbleitersubstrats (1) vorgesehenen zweiten Isolationsschicht (10);
**gekennzeichnet durch**
eine auf der zweiten Isolationsschicht (10) vorgesehenen leitenden Schicht (20), welche einen Kanalbereich (35) oberhalb der Floating-Gate-Elektrode (45) bildet; und
einen in der leitenden Schicht (20) jeweils neben dem Kanalbereich (35) gebildeten Sourcebereich (30) und Drainbereich (40).

2. Halbleiter-Speicherzelle nach Anspruch 1,
**dadurch gekennzeichnet,**
**daß** die Control-Gate-Elektrode (80) ein Dotierungsbereich im Halbleitersubstrat (1) ist.

3. Halbleiter-Speicherzelle nach Anspruch 1 oder 2,
**dadurch gekennzeichnet,**
**daß** die Floating-Gate-Elektrode (45) eine Polysilizium-Füllung des Grabens (5) ist.

4. Halbleiter-Speicherzelle nach Anspruch 1, 2 oder 3,
**dadurch gekennzeichnet,**
**daß** die leitende Schicht (20) eine Epitaxieschicht aus Polysilizium ist.

5. Halbleiter-Speicherzelle nach einem der vorhergehenden Ansprüche, **dadurch gekennzeichnet,**
**daß** neben dem Graben (5) STI-Gräben (60, 70) zur Isolation gegenüber benachbarten Speicherzellen vorgesehen sind.

6. Verfahren zum Herstellen einer Halbleiter-Speicherzelle mit den Schritten:
Bereitstellen von einem Halbleitersubstrat (1);
Bilden eines Grabens (5) in dem Halbleitersubstrat (1);
Bilden einer ersten Isolationsschicht (50) auf den Grabenwänden;
Bilden einer Floating-Gate-Elektrode (45) in dem Graben (5), welche durch die erste Isolationsschicht (50) von den Grabenwänden isoliert ist;
Bilden einer Control-Gate-Elektrode (80) in dem Halbleitersubstrat (1) um den Graben (5) herum;
Vorsehen einer zweiten Isolationsschicht (10) auf der Oberfläche des Halbleitersubstrats (1); **gekennzeichnet durch**
Vorsehen einer leitenden Schicht (20) auf der zweiten Isolationsschicht (10), welche einen Kanalbereich (35) oberhalb der Floating-Gate-Elektrode (45) bildet; und
Bilden von einem Sourcebereich (30) und einem Drainbereich (40) in der leitenden Schicht (20) jeweils neben dem Kanalbereich (35).

7. Verfahren nach Anspruch 6,
**dadurch gekennzeichnet,**
**daß** die Control-Gate-Elektrode (80) durch Umdotierung des Halbleitersubstrats (1) gebildet wird.

8. Verfahren nach Anspruch 6 oder 7,
**dadurch gekennzeichnet,**
**daß** die die Floating-Gate-Elektrode (45) durch Füllen des Grabens (5) gebildet wird.

9. Verfahren nach Anspruch 6, 7 oder 8,
**dadurch gekennzeichnet,**
**daß** die leitende Schicht (20) als Epitaxieschicht gebildet wird.

10. Verfahren nach einem der Ansprüche 6 bis 9,
**dadurch gekennzeichnet,**
**daß** neben dem Graben (5) STI-Gräben (60, 70) zur Isolation gegenüber benachbarten Speicherzellen vorgesehen werden.

## Claims

1. Semiconductor memory cell having:
a semiconductor substrate (1);
a trench (5) provided in the semiconductor substrate (1) ;
a floating gate electrode (45) introduced in the trench (5), which electrode is insulated from the trench walls by a first insulation layer (50);
a control gate electrode (80) provided in the semiconductor substrate (1) around the trench (5);
a second insulation layer (10) provided on the surface of the semiconductor substrate (1);
**characterized by**
a conductive layer (20) provided on the second insulation layer (10), which conductive layer forms a channel region (35) above the floating gate electrode (45); and
a source region (30) and drain region (40) formed in the conductive layer (20) in each case beside the channel region (35).

2. Semiconductor memory cell according to Claim 1,
**characterized**
**in that** the control gate electrode (80) is a doping region in the semiconductor substrate (1).

3. Semiconductor memory cell according to Claim 1 or 2,
**characterized**
**in that** the floating gate electrode (45) is a polysilicon filling of the trench (5).

4. Semiconductor memory cell according to Claim 1, 2 or 3,
**characterized**
**in that** the conductive layer (20) is an epitaxial layer made of polysilicon.

5. Semiconductor memory cell according to one of the preceding claims,
**characterized**
**in that** STI trenches (60, 70) for insulation with respect to adjacent memory cells are provided beside the trench (5).

6. Method for fabricating a semiconductor memory cell having the steps of:
providing a semiconductor substrate (1);
forming a trench (5) in the semiconductor substrate (1) ;
forming a first insulation layer (50) on the trench walls;
forming a floating gate electrode (45) in the trench (5), which electrode is insulated from the trench walls by the first insulation layer (50);
forming a control gate electrode (80) in the semiconductor substrate (1) around the trench (5);
providing a second insulation layer (10) on the surface of the semiconductor substrate (1); **characterized by**
providing a conductive layer (20) on the second insulation layer (10), which conductive layer forms a channel region (35) above the floating gate electrode (45); and
forming a source region (30) and a drain region (40) in the conductive layer (20) in each case beside the channel region (35).

7. Method according to Claim 6,
**characterized**
**in that** the control gate electrode (80) is formed by doping reversal of the semiconductor substrate (1).

8. Method according to Claim 6 or 7,
**characterized**
**in that** the floating gate electrode (45) is formed by filling the trench (5).

9. Method according to Claim 6, 7 or 8,
**characterized**
**in that** the conductive layer (20) is formed as an epitaxial layer.

10. Method according to one of Claims 6 to 9,
**characterized**
**in that** STI trenches (60, 70) for insulation with respect to adjacent memory cells are provided beside the trench (5).

## Revendications

1. Cellule de mémoire à semi-conducteurs avec :
- un substrat semi-conducteur (1) ;
- une tranchée (5) prévue dans le substrat semi-conducteur (1) ;
- une électrode à grille flottante (45) qui est placée dans la tranchée (5) et qui est isolée des parois de tranchée par une première couche isolante (50) ;
- une électrode à grille de contrôle (80) prévue dans le substrat semi-conducteur (1) autour de la tranchée (5) ;
- une deuxième couche isolante (10) prévue sur la surface du substrat semi-conducteur (1) ;
**caractérisée par** :
- une couche conductrice (20) qui est prévue sur la deuxième couche isolante (10) et qui forme une zone de canal (35) au-dessus de l'électrode à grille flottante (45) ; et
- une zone de source (30) et une zone de drain (40) formées dans la couche conductrice (20) chacune à côté de la zone de canal (35).

2. Cellule de mémoire à semi-conducteurs selon la revendication 1, **caractérisée par le fait que** l'électrode à grille de contrôle (80) est une zone dopée dans le substrat semi-conducteur (1).

3. Cellule de mémoire à semi-conducteurs selon la revendication 1 ou 2, **caractérisée par le fait que** l'électrode à grille flottante (45) est un remplissage en polysilicium de la tranchée (5).

4. Cellule de mémoire à semi-conducteurs selon la revendication 1, 2 ou 3, **caractérisée par le fait que** la couche conductrice (20) est une couche épitaxiale en polysilicium.

5. Cellule de mémoire à semi-conducteurs selon l'une des revendications précédentes, **caractérisée par le fait que** des tranchées STI (60, 70) sont prévues à côté de la tranchée (5) pour l'isolation par rapport à des cellules de mémoire voisines.

6. Procédé de fabrication d'une cellule de mémoire à semi-conducteurs comportant les étapes suivantes :
- préparation d'un substrat semi-conducteur (1) ;
- formation d'une tranchée (5) dans le substrat semi-conducteur (1) ;
- formation d'une première couche isolante (50) sur les parois de tranchée ;
- formation d'une électrode à grille flottante (45) dans la tranchée (5), laquelle électrode à grille flottante est isolée des parois de tranchée par la première couche isolante (50) ;
- formation d'une électrode à grille de contrôle (80) dans le substrat semi-conducteur (1) autour de la tranchée (5) ;
- préparation d'une deuxième couche isolante (10) sur la surface du substrat semi-conducteur (1) ;
**caractérisé par** :
- la préparation d'une couche conductrice (20) sur la couche isolante (10), laquelle couche conductrice forme une zone de canal (35) au-dessus de l'électrode à grille flottante (45) ; et
- la formation d'une zone de source (30) et d'une zone de drain (40) dans la couche conductrice (20) chacune à côté de la zone de canal (35).

7. Procédé selon la revendication 6, **caractérisé par le fait que** l'électrode de grille de contrôle (80) est formée par dopage du substrat semi-conducteur (1).

8. Procédé selon la revendication 6 ou 7, **caractérisé par le fait que** l'électrode à grille flottante (45) est formée par remplissage de la tranchée (5).

9. Procédé selon la revendication 6, 7 ou 8, **caractérisé par le fait que** la couche conductrice (20) est formée comme couche épitaxiale.

10. Procédé selon l'une des revendications 6 à 9, **caractérisé par le fait que** des tranchées STI (60, 70) sont prévues à côté de la tranchée (5) pour l'isolation par rapport à des cellules de mémoire voisines.
